# EUROPEAN PATENT APPLICATION

(11) **EP 2 930 155 A1**
(43) Date of publication of application: **14.10.2015**
(21) Application number: 13861161.1
(22) Date of filing: 20.11.2013
(51) Int. Cl.: C03B 23/023, C03C 21/00, G09F 9/00

(54) **METHOD FOR MANUFACTURING REINFORCED GLASS PLATE HAVING CURVED SECTIONS, AND REINFORCED GLASS PLATE HAVING CURVED SECTIONS**

(30) Priority: 07.12.2012 JP 2012268522; 12.11.2013 JP 2013233899
(71) Applicant: Nippon Electric Glass Co., Ltd., Otsu-shi Shiga 520-8639 (JP)
(72) Inventor: TAKEUCHI, Hirokazu, Otsu-shi Shiga 520-8639 (JP); WADA, Masanori, Otsu-shi Shiga 520-8639 (JP); ODANI, Osamu, Otsu-shi Shiga 520-8639 (JP); IKEMOTO, Masayuki, Otsu-shi Shiga 520-8639 (JP); TABE, Masashi, Otsu-shi Shiga 520-8639 (JP)
(74) Representative: Tetzner, Michael
(86) International application number: PCT/JP2013/081301
(87) International publication number: WO 2014/087841

(57) **Abstract**

Provided is a method capable of producing a glass sheet with a bent portion with a high form accuracy.

A reinforced glass sheet 1 with a flattened portion 11 and bent portions 12a and 13a continued to the flattened portion 11 is produced. A reinforcement step and a deformation step are performed. At the reinforcement step, a flat glass sheet is chemically reinforced to obtain a reinforced flat glass sheet 50. At the deformation step, the reinforced flat glass sheet 50 is heated and deformed to obtain the reinforced glass sheet 1 with the flattened portion 11 and the bent portions 12a and 13a.

## Description

### Technical Field

The present invention relates to a method for producing a reinforced glass sheet with a bent portion and a reinforced glass sheet with a bent portion.

### Background Art

In recent years, mobile devices including displays such as cellular phones, smart phones, notebook personal computers, tablet personal computers have been widely used (hereinafter, mobile devices including displays will be referred to as "mobile displays").

Patent Literature 1 discloses a cover glass usable for mobile displays. The cover glass disclosed in Patent Literature 1 includes a front surface portion positioned on the front surface of an image display part, and a bent portion bent from the front surface portion at both sides of the image display part in a width direction.

Patent Literature 1 discloses a method for producing a cover glass consisting of chemically reinforced glass, in which a flat glass sheet is heated and formed in a shape with a bent portion and then is chemically reinforced.

### Citation List

### Patent Literature

Patent Literature 1: JP-A-2012-101975

### Summary of Invention

### Technical Problem

The producing method disclosed in Patent Literature 1 has a problem that it is difficult to obtain a cover glass with a high form accuracy.

A principal object of the present invention is to provide a method capable of producing a reinforced glass sheet with a bent portion with a high form accuracy.

### Solution to Problem

The method for producing a reinforced glass sheet with a bent portion according to the present invention relates to a method for producing a reinforced glass sheet including a flattened portion and a bent portion continued to the flattened portion. The method for producing a reinforced glass sheet with a bent portion according to the present invention includes a reinforcement step and a deformation step. At the reinforcement step, a flat glass sheet is chemically reinforced to obtain a reinforced flat glass sheet. At the deformation step, the reinforced glass sheet is heated and deformed to obtain a reinforced glass sheet with a flattened portion and a bent portion.

The temperature of heating the flat glass sheet at the reinforcement step is preferably set to a temperature lower by 50°C or more than the strain point of the reinforced flat glass sheet.

The reinforcement step is preferably performed such that the compressive stress layer depth (Depth of Layer: DOL) of a portion of the reinforced flat glass sheet for forming the bent portion falls below a predetermined compressive stress layer depth (DOL) range, and the compressive stress value (Compressive Stress: CS) of the portion of the reinforced flat glass sheet for forming the bent portion exceeds a predetermined compressive stress value (CS) range.

The reinforcement step is preferably performed such that the compressive stress layer depth (DOL) of a portion of the reinforced flat glass sheet for forming the flattened portion falls below a predetermined compressive stress layer depth (DOL) range, and the compressive stress value (CS) of the portion of the reinforced flat glass sheet for forming the flattened portion exceeds a predetermined compressive stress value (CS) range.

The deformation step is preferably performed such that the temperature of the portion of the reinforced flat glass sheet for forming the flattened portion is lower than the temperature of the portion of the reinforced flat glass sheet for forming the bent portion.

The reinforced glass sheet produced by the method for producing a reinforced glass sheet with a bent portion according to the present invention is preferably a display cover glass.

The reinforced glass sheet with a bent portion according to the present invention includes a flattened portion and a bent portion continued to the flattened portion. The compressive stress value (CS) of the bent portion is lower than the compressive stress value (CS) of the flattened portion.

The reinforced glass sheet with a bent portion according to the present invention is a reinforced glass sheet including a flattened portion and a bent portion continued to the flattened portion. The compressive stress layer depth (DOL) of the bent portion is greater than the compressive stress layer depth (DOL) of the flattened portion.

It is preferred that the reinforced glass sheet with a bent portion according to the present invention is a display cover glass.

### Advantageous Effects of Invention

According to the present invention, it is possible to provide a method for producing a reinforced glass sheet with a bent portion with a high form accuracy.

### Brief Description of Drawings

Fig. 1 is a flowchart of a manufacturing process for a display cover glass according to an embodiment of the present invention.
Fig. 2 is a schematic cross-sectional view of a display cover glass according to the embodiment of the present invention.
Fig. 3 is a schematic cross-sectional view for illustrating a production step for the display cover glass according to the embodiment of the present invention.
Fig. 4 is a schematic perspective view of the display cover glass produced according to the embodiment of the present invention.
Fig. 5 is a graph showing a compressive stress value (CS) and a compressive stress layer depth (DOL) after a reinforcement step, and a compressive stress value (CS) and a compressive stress layer depth (DOL) after a reinforcement step.

### Description of Embodiments

Hereinafter, a description will be given of an exemplary preferred embodiment of the present invention. However, the following embodiment is merely illustrative. The present invention is not at all limited to the following embodiment.

Throughout the drawings to which the embodiment and the like refer, elements having substantially the same functions will be referred to by the same reference signs. The drawings to which the embodiment and the like refer are schematically illustrated. The dimensional ratios and the like of objects illustrated in the drawings may be different from those of the actual objects. Different drawings may have different dimensional ratios and the like of the objects. Dimensional ratios and the like of specific objects should be determined in consideration of the following descriptions.

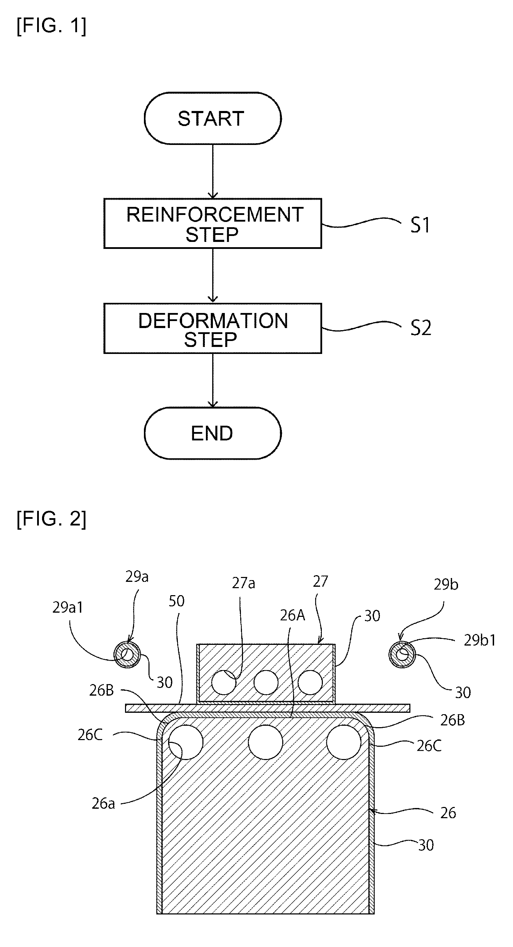

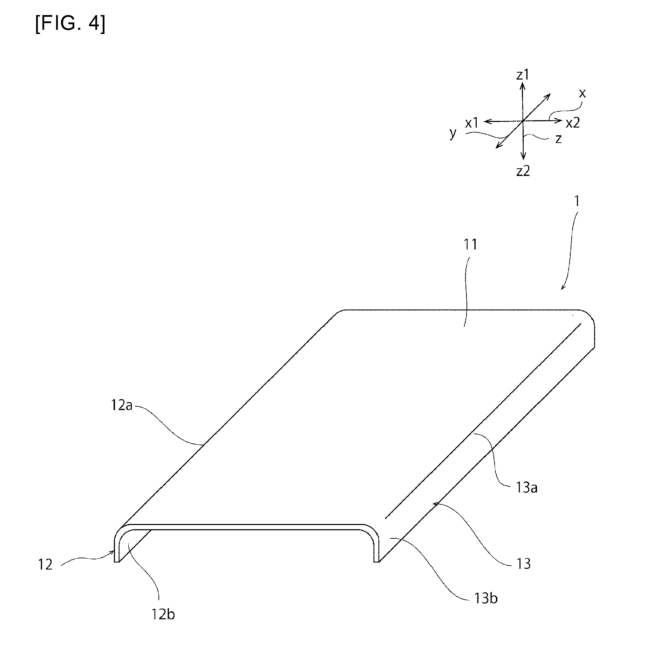

Referring to Figs. 1 to 5, a description will be given as to this embodiment in which a display cover glass 1 shown in Fig. 4 is manufactured. However, the method for producing a reinforced glass sheet with a bent portion according to the present invention is not limited to the method described below. In the present invention, a reinforced glass sheet with a bent portion may be a glass sheet other than the display cover glass 1.

Prior to description of the method for producing the display cover glass 1, a configuration of the display cover glass 1 produced in this embodiment will be described with reference to Fig. 4.

### (Display cover glass 1)

The display cover glass 1 is a cover glass covering at least part of a display portion and side surfaces of a display. More specifically, the display cover glass 1 covers a display portion and at least part of both side surfaces along an x axis direction of the display. No particular limitation is placed on the display as far as the display is a device with a display. For example, the display may be a mobile device such as a cellular phone, smart phone, notebook personal computer, tablet personal computer, or the like. The display may be plate-like.

The display cover glass 1 is consisted of a chemically reinforced glass sheet made of chemically reinforced glass, for example. The entire display cover glass 1 is preferably reinforced, but the entire display cover glass 1 may not be necessarily reinforced. At least part of the display cover glass 1 needs to be reinforced. Of the display cover glass 1, at least a flattened portion 11 is preferably reinforced.

Although there is no particular limitation, the display cover glass 1 has a thickness of preferably 0.2 mm to 1.5 mm, more preferably 0.25 mm to 1.1 mm, further preferably 0.3 mm to 1.0 mm.

The display cover glass 1 has the flattened portion 11. The flattened portion 11 is located at the front side of the display portion of the display. Thus, from the viewpoint of improving display quality of the display, the flattened portion 11 is required to have a higher form accuracy. In this configuration, the front side is made along a direction (Z1 side) in which a perpendicular line of the display portion extends, and the back side is made along an opposite direction (Z2 side) of the direction (Z1 side) in which the perpendicular line extends.

The flattened portion 11 has a flat-sheet shape. The flattened portion 11 is rectangular. The dimension of the flattened portion 11 along the x axis direction may be about 40 mm to 200 mm, for example. The dimension of the flattened portion 11 along a y axis direction may be 80 mm to 300 mm, for example. The "flat-sheet shape" also means a virtually flat-sheet shape. For example, the "flat sheet" includes a sheet that has one plane and other planes inclined at an angle of 5° or less with respect to the one plane.

A first side surface portion 12 is continued to an x1-side end of the flattened portion 11 along the x axis direction. The first side surface portion 12 is located at a side of the display. Specifically, the first side surface portion 12 is located at the x1 side of the display along the x axis direction.

The first side surface portion 12 includes a first bent portion 12a. The first bent portion 12a is continued to the flattened portion 11. The first bent portion 12a is bent from the x1-side end of the flattened portion 11 along the x axis direction toward the back side (Z2 side). A bend angle formed by a tangent line of an inner wall surface at the x1-side end portion of the flattened portion 11 and a tangent line of an inner wall surface at a leading end of the first side surface portion 12 is preferably 90° to 170°, more preferably 90° to 150°.

In this embodiment, the first side surface portion 12 has the first bent portion 12a and a first flattened portion 12b continued to the leading end of the first bent portion 12a. However, the present invention is not limited to this configuration. The first side surface portion 12 may be consisted only of the first bent portion 12a.

A second side surface portion 13 is continued to an x2-side end portion of the flattened portion 11 along the x axis direction. The second side surface portion 13, the flattened portion 11, and the first side surface portion 12 are formed by one glass sheet. The second side surface portion 13 is located at a side of the display. Specifically, the second side surface portion 13 is located at the x2 side of the display along the x axis direction.

The second side surface portion 13 includes a second bent portion 13a. The second bent portion 13a is continued to the flattened portion 11. The second bent portion 13a is bent from the x2-side end portion of the flattened portion 11 along the x axis direction toward the back side (Z2 side). A bend angle formed by the flattened portion 11 and the second side surface portion 13 is preferably 90° to 170°, more preferably 90° to 150°.

In this embodiment, the second side surface portion 13 has the second bent portion 13a and a second flattened portion 13b continued to the leading end of the second bent portion 13a. However, the present invention is not limited to this configuration. The second side surface portion 13 may be consisted only of the second bent portion 13a.

At least one of the pair of side surfaces of the display may constitute the display portion displaying images. That is, the side surface portions 12 and 13 may be positioned on the side surfaces constituting the display portion.

In the display cover glass 1 of this embodiment, the compressive stress value (CS) of the bent portions 12a and 13a is lower than the compressive stress value (CS) of the flattened portion 11. Even in this case, since the compressive stress value (CS) of the flattened portion 11 positioned on the display portion is high, the display cover glass 1 is less prone to be broken even if the flattened portion 11 is scratched.

### (Method for producing the display cover glass 1)

Next, the method for producing the display cover glass 1 will be described. As shown in Fig. 1, in this embodiment, a reinforcement step is performed at step S1 and then a deformation step is performed at step S2.

At the reinforcement step, first, a flat glass sheet is prepared. The flat glass sheet is made of glass for reinforcement that contains sodium ions capable of being ion-reinforced. The flat glass sheet is immersed in potassium acetate melt, for example, to cause sodium ions to be released from a surface layer of the flat glass sheet and potassium ions to be taken into the surface layer of the flat glass sheet. Accordingly, a compressive stress layer is formed on the surface layer of the flat glass sheet. Then, the flat glass sheet is removed from the potassium acetate melt and cooled, thereby obtaining a reinforced flat glass sheet 50 (refer to Fig. 2). The depth of the compressive stress layer is called compressive stress layer depth (DOL), and the compressive stress value of the compressive stress layer is called CS. The compressive stress layer depth (DOL) and the compressive stress value (CS) can be measured by using FMS-6000 manufactured by Orihara Manufacturing Co., Ltd., for example.

In the reinforced flat glass sheet 50, the compressive stress layer depth (DOL) is preferably 10 µm to 60 µm, more preferably 10 µm to 50 µm. In the reinforced flat glass sheet 50, the compressive stress value (CS) is preferably 400 MPa to 1200 MPa, more preferably 500 MPa to 1200 MPa. In particular, the compressive stress layer depth (DOL) of a portion of the reinforced flat glass sheet 50 corresponding to the flattened portion 11 is preferably 10 µm to 40 µm, more preferably 15 µm to 30 µm. The compressive stress value (CS) of a portion of the reinforced flat glass sheet 50 corresponding to the flattened portion 11 is preferably 500 MPa to 1200 MPa, more preferably 800 MPa to 1200 MPa. The compressive stress layer depth (DOL) of portions of the reinforced flat glass sheet 50 corresponding to the bent portions 12a and 13a is preferably 10 µm to 60 µm, more preferably 10 µm to 50 µm. The compressive stress value (CS) of the portions of the reinforced flat glass sheet 50 corresponding to the bent portions 12a and 13a is preferably 500 MPa to 1000 MPa, more preferably 500 MPa to 900 MPa.

The temperature of the potassium acetate melt at the reinforcement step, that is, the heating temperature of the flat glass sheet is preferably higher than the melting point of potassium acetate and lower by 50°C or more than the strain point of the reinforced flat glass sheet, more preferably higher than the melting point of potassium acetate and lower by 100°C or more than the strain point of the reinforced flat glass sheet, for example. This is because, if the heating temperature of the flat glass sheet is too high, structural relaxation of glass by heating becomes more dominant to decrease the compressive stress value (CS).

Next, the obtained reinforced flat glass sheet 50 is subjected to the deformation step, thereby completing the display cover glass 1. Specifically, the reinforced flat glass sheet 50 is heated and deformed to complete the display cover glass 1.

More specifically, while the reinforced flat glass sheet 50 is sandwiched between a first forming die 26 and a second forming die 27, the atmospheric temperature is raised to heat the reinforced flat glass sheet 50. The reinforced flat glass sheet 50 is preferably heated so that the temperature of portions of the reinforced flat glass sheet 50 for forming the bent portions 12a and 13a does not exceed the softening point of the reinforced flat glass sheet 50. The deformation step is preferably performed so that the temperature of portions of the reinforced flat glass sheet 50 for forming the bent portions 12a and 13a is higher than the glass transition point and lower than the softening point, more preferably, so that the temperature is higher than the glass transition point and lower by 40°C or more than the softening point, most preferably, so that the temperature is higher than the glass transition point and lower by 130°C or more than the softening point.

Specifically, the reinforced flat glass sheet 50 is placed on the first forming die 26 such that a portion of the reinforced flat glass sheet 50 for forming the flattened portion 11 is positioned on the first forming die 26. Of the reinforced flat glass sheet 50, the substantially entire portion for forming the flattened portion 11 is sandwiched between the first forming die 26 and the second forming die 27.

The first forming die 26 is provided with through holes 26a to which a refrigerant such as air is supplied. The first forming die 26 is cooled by supplying the refrigerant to the through holes 26a. Similarly, the second forming die 27 is provided with through holes 27a to which a refrigerant such as air is supplied. The second forming die 27 is cooled by supplying the refrigerant to the through holes 27a. Accordingly, at the deformation step, the temperature of the portion of the reinforced flat glass sheet 50 for forming the flattened portion 11 is lower than the temperature of the portions of the reinforced flat glass sheet 50 for forming the side surface portions 12 and 13 including the bent portions 12a and 13a.

The first forming die 26 has a first flat forming surface 26A for forming the flattened portion 11, second curved forming surfaces 26B for forming the bent portions 12a and 13a, and third flat forming surfaces 26C for forming the flattened portions 12b and 13b. The second forming surfaces 26B are curved surfaces suited to the shapes of the bent portions 12a and 13a.

The first forming die 26 is consisted of a hard material such as ceramics, metal, or the like. The second forming die 27 is also consisted of a hard material such as ceramics, metal, or the like. The first and second forming dies 26 and 27 may be consisted of a heat insulating material made of a porous body or the like.

A buffer member 30 is disposed at least on the first forming surface 26A of the first forming die 26. In this embodiment, the buffer member 30 is disposed not only on the first forming surface 26A but also on the second and third forming surfaces 26B and 26C. The buffer member 30 covers the first to third forming surfaces 26A to 26C. Similarly, the buffer member 30 is also disposed on the surface of the second forming die 27 contacting the reinforced flat glass sheet 50. The buffer members 30 make it possible to suppress occurrence of scratches or the like on the display cover glass 1 to be produced.

The buffer members 30 are members capable of being elastically deformed in a thickness direction. The buffer members 30 are preferably consisted of at least either woven cloth or non-woven cloth made of alumina fiber, glass fiber, carbon fiber, or the like, for example. The thickness of the buffer members 30 is preferably about 0.1 mm to 2 mm, for example.

The reinforced flat glass sheet 50 is heated until the portions of the reinforced flat glass sheet 50 for forming the bent portions 12a and 13a (end portions of the reinforced flat glass sheet 50 along the width direction) have a viscosity with which both plastic deformation and elastic deformation take place. In general, when the viscosity of the reinforced flat glass sheet 50 is 10⁸ dPa·s or less, the reinforced flat glass sheet 50 is not elastically deformed but is plastically deformed. Meanwhile, when the viscosity of the reinforced flat glass sheet 50 is 10¹¹ dPa·s or more, the reinforced flat glass sheet 50 is not plastically deformed but is elastically deformed. When the viscosity of the reinforced flat glass sheet 50 is about between 10⁸ dPa·s and 10¹¹ dPa·s, the reinforced flat glass sheet 50 is plastically deformed and elastically deformed. Therefore, the reinforced flat glass sheet 50 is preferably heated so that the viscosity of the reinforced flat glass sheet 50 is between about 10^{8.5} dPa·s and 10^{10.5} dP·s, more preferably, the viscosity of the reinforced flat glass sheet 50 is about between 10⁹ dPa·s and 10¹⁰ dPa·s. The temperature of the reinforced flat glass sheet 50 at which the viscosity of the reinforced flat glass sheet 50 is about between 10⁸ dPa·s and 10¹¹ dPa·s varies depending on the composition of the reinforced flat glass sheet 50.

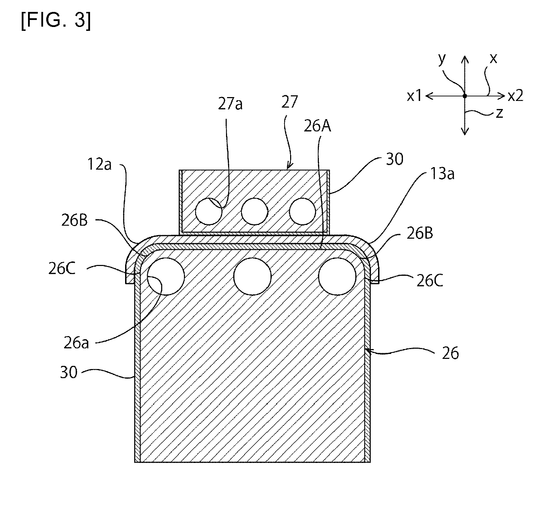

Next, press tools 29a and 29b are used to press the end portions of the reinforced flat glass sheet 50 toward the first forming die 26 side, thereby to deform the end portions of the reinforced flat glass sheet 50. Accordingly, as shown in Fig. 3, the bent portions 12a and 13a are formed to complete the display cover glass 1 shown in Figs. 3 and 4. The deformation step is performed while a refrigerant is supplied to through hole 29a1 of the press tool 29a and through hole 29b1 of the press tool 29b to cool the press tools 29a and 29b.

Although the press tools 29a and 29b may be consisted of ceramics or glass, for example, the press tools 29a and 29b in this embodiment are consisted of metal as an elastic body. The buffer members 30 are provided on portions of the press tools 29a and 29b contacting the reinforced flat glass sheet 50. Specifically, in this embodiment, the press tools 29a and 29b are covered with the buffer members 30.

After the reinforcement of a flat glass sheet, it is difficult to form the flat glass sheet. When a reinforced flat glass is heated, potassium ions unevenly distributed in the compressive stress layer diffuse toward the center of the flat glass sheet. Accordingly, the reinforced glass sheet tends to have a lower compressive stress value (CS). Therefore, in general, a flat glass sheet is formed in a desired shape and then is chemically reinforced.

However, the inventors of the present invention have conducted earnest research and found that, even if a glass sheet is changed in shape between before and after chemical reinforcement and then is formed with a high form accuracy at the forming step, when the glass sheet is subjected to the reinforcement step after the forming step, the glass sheet is decreased in form accuracy. Therefore, when performing the reinforcement step after the forming step, it is difficult to obtain the display cover glass 1 with a high form accuracy.

While on the other hand, in this embodiment, first, the reinforcement step is performed at step S1 and then the deformation step is performed at step S2. Accordingly, after the deformation step, the reinforcement step causing a shape change may not be necessarily performed. Therefore, it is possible to produce the display cover glass 1 with a high form accuracy.

In this embodiment, however, the compressive stress value (CS) of the reinforced flat glass sheet 50 tends to decrease at the deformation step. In particular, the portions of the reinforced flat glass sheet 50 for forming the side surface portions 12 and 13 are higher in temperature than the portion of the reinforced flat glass sheet 50 for forming the flattened portion 11. Accordingly, the compressive stress value (CS) of the bent portions 12a and 13a tends to be lower than the compressive stress value (CS) of the flattened portion 11.

From the viewpoint of suppressing a decrease in the compressive stress value (CS) due to diffusion of potassium ions at the deformation step, it is important to perform the reinforcement step and the deformation step of the flat glass sheet at low temperatures. Specifically, the reinforcement step is preferably performed such that the heating temperature of the flat glass sheet at the reinforcement step is preferably lower by 50°C or more than the strain point of the reinforced flat glass sheet, more preferably, lower by 100°C or more than the strain point of the reinforced flat glass sheet.

In addition, the deformation step is preferably performed such that the temperature of the portions of the reinforced flat glass sheet 50 for forming the bent portions 12a and 13a at the deformation step does not exceed the softening point of the reinforced flat glass sheet 50, more specifically such that the temperature is higher than the glass transition point and lower than the softening point, further preferably such that the temperature is higher than the glass transition point and lower by 40°C or more than the softening point, most preferably such that the temperature is higher than the glass transition point and lower by 130°C or more than the softening point.

In order to further suppress a decrease in the compressive stress value (CS) of the flattened portion 11 required to have a higher compressive stress value (CS), the deformation step is preferably performed such that the temperature of the portion of the reinforced flat glass sheet 50 for forming the flattened portion 11 is lower than the temperature of the portions of the reinforced flat glass sheet 50 for forming the bent portions 12a and 13a. Specifically, the deformation step is preferably performed such that the foregoing temperature is equal to or less than the glass transition point of the reinforced flat glass sheet, more preferably such that the temperature is lower by 10°C than the glass transition point, more preferably such that the temperature is higher than the glass strain point and lower by 30°C or more than the glass transition point.

In addition, from the viewpoint of further increasing the compressive stress value (CS) of the flattened portions 12b and 13b, the deformation step is preferably performed while the press tools 29a and 29b are cooled to suppress a temperature rise at the portions of the reinforced flat glass sheet 50 for forming the flattened portions 12b and 13b at the deformation step.

However, it is difficult to perfectly control a decrease in the compressive stress value (CS) at the deformation step. Therefore, it is preferred to set the compressive stress layer depth (DOL) of the reinforced flat glass sheet 50 lower than the design value of the compressive stress layer depth (DOL) of the display cover glass 1, and set the compressive stress value (CS) of the reinforced flat glass sheet 50 higher than the design value of the compressive stress value (CS) of the display cover glass 1, and set the compressive stress layer depth (DOL) and the compressive stress value (CS) of the reinforced flat glass sheet 50 at the deformation step identical to the design value of the compressive stress layer depth (DOL) and the design value of the compressive stress value (CS), respectively. Specifically, the settings are made in this embodiment as described below.

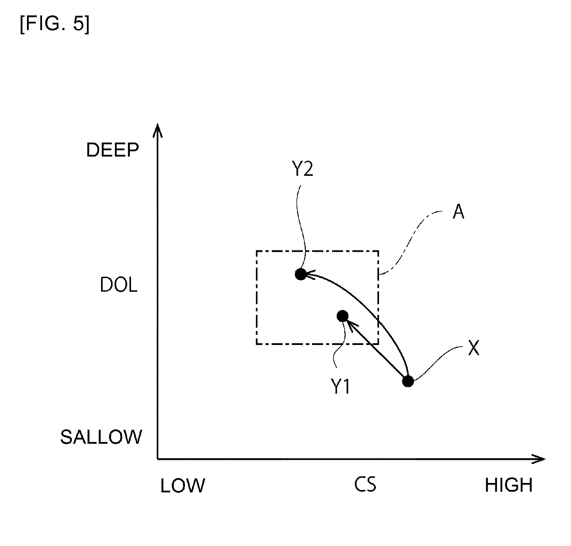

Region A shown in Fig. 5 indicates a predetermined compressive stress layer depth (DOL) range and a compressive stress value (CS) range (an allowable compressive stress layer depth (DOL) range and an allowable compressive stress value (CS) range of the display cover glass 1). Point X denotes the compressive stress layer depth (DOL) and compressive stress value (CS) of the reinforced flat glass sheet 50. Point Y1 denotes the compressive stress layer depth (DOL) and compressive stress value (CS) of the flattened portion 11 of the produced display cover glass 1. Point Y2 denotes the compressive stress layer depth (DOL) and compressive stress value (CS) of the bent portions 12a and 13a of the produced display cover glass 1.

First, the reinforcement step is performed such that the point X is positioned within a region with a compressive stress layer depth (DOL) below the region A and with a compressive stress value (CS) beyond the region A. Since diffusion of potassium ions takes place at the subsequent deformation step, the compressive stress layer depth (DOL) of points Y1 and Y2 becomes greater than the compressive stress layer depth (DOL) of the point X. Meanwhile, the compressive stress values (CS) of the points Y1 and Y2 become lower than the compressive stress value (CS) of the point X. Since the portions of the reinforced flat glass sheet 50 for forming the bent portions 12a and 13a become higher in temperature than the portion of the reinforced flat glass sheet 50 for forming the flattened portion 11, the compressive stress layer depth (DOL) of the point Y2 becomes greater than the compressive stress layer depth (DOL) of the point Y1, and the compressive stress value (CS) of the point Y2 becomes lower than the compressive stress value of the point Y1. The reinforcement step is preferably performed such that the points Y1 and Y2 are located within the region A, taking into account the amounts of changes in the compressive stress layer depth (DOL) and the compressive stress value (CS) at the deformation step. Accordingly, it is possible to obtain the display cover glass 1 with the desired compressive stress layer depth (DOL) and compressive stress value (CS).

In the foregoing description, the compressive stress layer depth (DOL) range and compressive stress value (CS) range predetermined for the flattened portion 11 and the compressive stress layer depth (DOL) range and compressive stress value (CS) range predetermined for the bent portions 12a and 13a are the same. However, the compressive stress layer depth (DOL) range and compressive stress value (CS) range predetermined for the flattened portion 11 and the compressive stress layer depth (DOL) range and compressive stress value (CS) range predetermined for the bent portions 12a and 13a may be different from each other.

From the viewpoint of suppressing a decrease in the compressive stress value (CS) of the reinforced flat glass sheet 50, the deformation step may be performed while a member of nitrate potassium or the like with a higher concentration of potassium ions than that of the surface layer of the reinforced flat glass sheet 50, is in contact with the reinforced flat glass sheet 50.

### Reference Signs List

1...display cover glass
11...flattened portion
12...first side surface portion
12a...first bent portion
12b...first flattened portion
13...second side surface portion
13a...second bent portion
13b...second flattened portion
26...first forming die
26A...first forming surface
26B...second forming surface
26C...third forming surface
26a...through hole
27...second forming die
27a...through hole
29a, 29b...press tool
29a1, 29b1...through hole
30...buffer member
50...reinforced flat glass sheet

## Claims

1. A method for producing a reinforced glass sheet with a bent portion, the reinforced glass sheet including a flattened portion and the bent portion continued to the flattened portion, the method comprising:
a reinforcement step of chemically reinforcing a flat glass sheet to obtain a reinforced flat glass sheet; and
a deformation step of heating and deforming the reinforced flat glass sheet to obtain the reinforced glass sheet with the flattened portion and the bent portion.

2. The method for producing a reinforced glass sheet with a bent portion according to claim 1, wherein the heating temperature of the flat glass sheet at the reinforcement step is set to a temperature lower by 50°C or more than the strain point of the reinforced flat glass sheet.

3. The method for producing a reinforced glass sheet with a bent portion according to claim 1 or 2, wherein the reinforcement step is performed such that the compressive stress layer depth (DOL) of a portion of the reinforced flat glass sheet for forming the bent portion falls below a predetermined compressive layer depth (DOL) range and the compressive stress value (CS) of the portion of the reinforced flat glass sheet for forming the bent portion exceeds a predetermined compressive stress value (CS) range.

4. The method for producing a reinforced glass sheet with a bent portion according to any one of claims 1 to 3, wherein the reinforcement step is performed such that the compressive stress layer depth (DOL) of a portion of the reinforced flat glass sheet for forming the flattened portion falls below a predetermined compressive stress layer depth (DOL) range and the compressive stress value (CS) of the portion of the reinforced flat glass sheet for forming the flattened portion exceeds a predetermined compressive stress value (CS) range.

5. The method for producing a reinforced glass sheet with a bent portion according to any one of claims 1 to 4, wherein the deformation step is performed such that the temperature of the portion of the reinforced flat glass sheet for forming the flattened portion is lower than the temperature of the portion of the reinforced flat glass sheet for forming the bent portion.

6. The method for producing a reinforced glass sheet with a bent portion according to any one of claims 1 to 5, wherein the reinforced glass sheet is a display cover glass.

7. A reinforced glass sheet with a bent portion, the reinforced glass sheet including a flattened portion and the bent portion continued to the flattened portion, wherein
the compressive stress value (CS) of the bent portion is lower than the compressive stress value (CS) of the flattened portion.

8. A reinforced glass sheet with a bent portion, the reinforced glass sheet including a flattened portion and the bent portion continued to the flattened portion, wherein
the compressive stress layer depth (DOL) of the bent portion is greater than the compressive stress layer depth (DOL) of the flattened portion.

9. The reinforced glass sheet with a bent portion according to claim 7 or 8, wherein the reinforced glass sheet is a display cover glass.
